(19) Europäisches Patentamt
European Patent Office
Office européen des brevets

(11) **EP 2 027 648 B1**

(12) **EUROPÄISCHE PATENTSCHRIFT**

(45) Veröffentlichungstag und Bekanntmachung des Hinweises auf die Patenterteilung:
**07.07.2010 Patentblatt 2010/27**

(51) Int Cl.:
*H02P 21/00* *(2006.01)*       *H02P 9/00* *(2006.01)*
*H02P 6/00* *(2006.01)*

(21) Anmeldenummer: **07729685.3**

(22) Anmeldetag: **30.05.2007**

(86) Internationale Anmeldenummer:
**PCT/EP2007/055272**

(87) Internationale Veröffentlichungsnummer:
**WO 2007/144267 (21.12.2007 Gazette 2007/51)**

(54) **STROMBEGRENZUNG FÜR EINE DOPPELTGESPEISTE ASYNCHRONMASCHINE**

CURRENT LIMITATION FOR A DOUBLE-FED ASYNCHRONOUS MACHINE

LIMITEUR DE COURANT POUR UNE MACHINE ASYNCHRONE À DOUBLE ALIMENTATION

(84) Benannte Vertragsstaaten:
**AT BE BG CH CY CZ DE DK EE ES FI FR GB GR HU IE IS IT LI LT LU LV MC MT NL PL PT RO SE SI SK TR**

(30) Priorität: **12.06.2006 DE 102006027465**

(43) Veröffentlichungstag der Anmeldung:
**25.02.2009 Patentblatt 2009/09**

(73) Patentinhaber: **Woodward SEG GmbH & Co. KG**
**47906 Kempen (DE)**

(72) Erfinder:
• **ENGELHARDT, Stephan**
**47665 Sonsbeck (DE)**
• **GENIUSZ, Andrzej**
**45473 Mülheim an der Ruhr (DE)**

(74) Vertreter: **Bonsmann, Joachim Bernhard et al**
**Bonsmann & Bonsmann**
**Patentanwälte**
**Kaldenkirchener Strasse 35 a**
**41063 Mönchengladbach (DE)**

(56) Entgegenhaltungen:
**GB-A- 2 410 386        GB-A- 2 411 252**
**US-A1- 2003 052 643**

**Beschreibung**

Die vorliegende Erfindung betrifft ein Verfahren sowie eine Vorrichtung zur Regelung der abgegebenen oder aufgenommenen Wirk- und Blindleistung einer doppeltgespeisten Asynchronmaschine, bei der der Strom der Maschine begrenzt werden soll.

Die doppeltgespeiste Asynchronmaschine ist eine Asynchronmaschine, deren Stator im Allgemeinen mit einer Spannung konstanter Amplitude und Frequenz betrieben wird und beispielsweise mit einem elektrischen Netz verbunden ist. Der Rotor einer doppeltgespeisten Asynchronmaschine ist über Schleifringe elektrisch mit einem Umrichter, vorzugsweise einem Pulswechselrichter, verbunden. Dadurch kann im Rotor eine Spannung mit variabler Amplitude und Frequenz eingeprägt werden. Die doppeltgespeiste Asynchronmaschine ermöglicht den Betrieb mit konstanter Statorspannung bzw. Netzspannung und variabler Rotordrehzahl. Durch eine Steuereinheit kann der Umrichter so angesteuert werden, dass die von der doppeltgespeisten Asynchronmaschine abgegebene oder aufgenommene Wirk- und Blindleistung geregelt werden kann. Die doppeltgespeiste Asynchronmaschine wird beispielsweise in Windkraftanlagen hoher Leistung, als Wellengenerator oder in Verbindung mit Schwungmassenspeichern eingesetzt.

Zum Schutz der Maschine und des Umrichters vor thermischer Überlastung darf ein maximal zulässiger Strom nicht überschritten werden. Dabei ist ein maximal zulässiger statischer und ein maximal zulässiger dynamischer Strom zu unterscheiden.

Der maximal zulässige statische Strom kann von verschiedenen Faktoren abhängen, z.B. von der Schlupffrequenz der Maschine, der Umgebungstemperatur oder der Schaltfrequenz des Umrichters. Der maximal zulässige statische Strom hängt aber auch von der Kühlung der Maschine und des Umrichters ab. Bei forcierter Luftkühlung durch einen separaten Lüfter kann der zulässige Strom auch von der Lüfterspannung, die im Allgemeinen der Netzspannung entspricht, abhängen.

Bei Systemen mit Dauerlast ist die Festlegung eines maximal zulässigen statischen Stromes ausreichend. Bei Systemen mit stetig wechselnden Lasten besteht im Allgemeinen die Anforderung, ein definiertes Lastspiel zuzulassen, um das System nicht für eine Dauerlast entsprechend der maximalen Kurzzeitlast auslegen zu müssen. Dabei wird kurzzeitig ein Strom oberhalb des zulässigen Dauerstroms zugelassen. Im Allgemeinen wird vereinfachend davon ausgegangen, dass die Verlustleistungen und damit die thermische Belastung des Systems proportional zum Quadrat des Stromes steigen. Um das System nicht zu überlasten, muss sichergestellt werden, dass der zeitliche Mittelwert des Quadrates des Stromes das Quadrat des maximal zulässigen Dauerstroms nicht übersteigt. Auf diese Weise wird ein maximal zulässiger dynamischer Strom definiert.

Häufig wird zur Regelung der abgegebenen oder aufgenommenen Wirk- und Blindleistung einer doppeltgespeisten Asynchronmaschine eine Kaskadenstruktur der Regelung verwandt. Dabei gibt es jeweils einen Regler für Wirk- und Blindleistung. Die Ausgänge der Leistungsregler stellen die Sollwerte des Stromes für unterlagerte Stromregler dar. Die Sollwerte des Stromes werden mit den Istwerten verglichen. Die Differenzsignale bilden den Eingang für die unterlagerten Stromregler. Die Begrenzung des Stromes auf einen maximal zulässigen Wert, sei es nun ein maximal zulässiger statischer oder maximal zulässiger dynamischer Stromwert, kann bei einer solchen Anordnung sehr einfach durch Begrenzung der Ausgänge der Wirk- und Blindleistungsregler durchgeführt werden. Eine solche Regelstruktur hat jedoch deutliche Nachteile: Durch die Kaskadenstruktur mit den unterlagerten Stromreglern müssen Einschränkungen hinsichtlich der Dynamik hingenommen werden. Durch bestimmte Reglerstrukturen kann die Dynamik zwar verbessert werden, solche Reglerstrukturen stellen jedoch hohe Anforderungen an den Parameterabgleich. Nur eine sorgfältig auf die jeweilige Anlage abgestimmte Reglerstruktur kann die Dynamik der Regelung verbessern.

Aus der GB 2 411 252 A ist ein Verfahren bzw. eine Vorrichtung zur Regelung eines Stromes einer doppeltgespeisten Asynchronmaschine bekannt, bei dem bzw. bei der die aufgenommene oder abgegebene Wirk- und Blindleistung anhand vorgegebener Sollwerte geregelt werden.

Aus der GB 2 410 386 A ist es bekannt, bei einer doppeltgespeisten Asynchronmaschine die Ausgangsströme und -spannungen anhand vorgegebener Grenzwerte zu limitieren.

Aufgrund der oben beschriebenen Nachteile ist bei hochdynamischen Anforderungen ein Verzicht auf unterlagerte Stromregler anzustreben.

Hierzu ist es grundsätzlich denkbar, den Strom indirekt zu begrenzen, und zwar durch Begrenzung der Sollwerte der abgegebenen oder aufgenommenen Wirk- und Blindleistung. Hierzu wäre es denkbar, eine Kennlinie mit maximal zulässigen Sollwerten der abgegebenen oder aufgenommenen Wirk- und Blindleistung in Abhängigkeit von verschiedenen Einflussgrößen zu ermitteln und einzusetzen. Solche Einflussgrößen könnten zum Beispiel Spannung, Frequenz oder Drehzahl sein. Die vielen sonstigen Einflussgrößen würden allerdings unvermeidbar zu relativ großen Ungenauigkeiten der vorausberechneten Kennlinien führen. Dies hätte zur Folge, dass die Ströme in vielen Betriebszuständen stärker beschränkt werden müssten, als es zum Schutz der Anlage eigentlich erforderlich wäre. Der Umrichter und die Maschine müssten also bei einem solchen Schutzkonzept für eine entsprechend höhere Leistung ausgelegt werden, um eine Einhaltung der zulässigen Werte stets zu gewährleisten; eine derartige permanente Einhaltung der zulässigen Werte ist jedoch unverzichtbar.

Es ist daher die Aufgabe der vorliegenden Erfindung, den Strom einer doppeltgespeisten Asynchronmaschine, deren abgegebene oder aufgenommene Wirk- und Blindleistung geregelt wird, zuverlässig so zu begrenzen, dass die Dynamik der Leistungsregelung nicht beeinflusst wird und die Anlage für eine möglichst kleine Leistung ausgelegt werden kann.

Zur Lösung der vorstehend genannten Aufgabe wird ein Verfahren mit den Merkmalen des Patentanspruches 1 sowie eine Vorrichtung mit den Merkmalen des Patentanspruchs 14 vorgeschlagen.

Vorteilhafte Ausgestaltungen der Erfindung sind in den abhängigen Patentansprüchen beschrieben.

Zur Lösung der genannten Aufgabe wird ein Verfahren zur Begrenzung eines Stromes einer doppeltgespeisten Asynchronmaschine vorgeschlagen, wobei die abgegebene oder aufgenommene Wirk- und Blindleistung der doppeltgespeisten Asynchronmaschine geregelt wird, und wobei während des Betriebes der doppeltgespeisten Asynchronmaschine ein maximal zulässiger Sollwert der abzugebenden oder aufzunehmenden Wirkleistung und ein maximal zulässiger Sollwert der abzugebenden oder aufzunehmenden Blindleistung unter Zuhilfenahme eines Modells der Asynchronmaschine aus dem maximal zulässigen Strom derart bestimmt werden, dass dieser nicht überschritten wird, und wobei die vorgegebenen Wirk- und Blindleistungssollwerte auf die berechneten maximal zulässigen Werte begrenzt werden.

Bei der erfindungsgemäßen Lösung sind also keine unterlagerten Stromregler mehr erforderlich, da die Sollwerte der abgegebenen oder aufgenommenen Wirk- und Blindleistung begrenzt werden und die Strombegrenzung somit indirekt durchgeführt wird. Im Gegensatz zu einer vorstehend erörterten Kennlinienlösung werden die maximalen zulässigen Sollwerte der abgegebenen oder aufgenommenen Wirk- und Blindleistung nicht im Voraus berechnet, sondern während des Betriebes der doppeltgespeisten Asynchronmaschine - vorzugsweise unter Verwendung einer geeigneten Rückführung - berechnet. Dadurch können die maximal zulässigen Sollwerte der abzugebenden oder aufzunehmenden Wirk- und Blindleistung individuell für den jeweiligen Arbeitspunkt bestimmt werden.

In einer bevorzugten Ausführungsform der Erfindung wird bei der Berechnung der maximal zulässigen Sollwerte für die Wirk- und Blindleistung wenigstens der Istwert des zu begrenzenden Stromes zur Korrektur herangezogen.

Gemäß der Erfindung wird bei Angabe einer Priorität Wirkleistung zuerst der maximal zulässige Sollwert der abzugebenden oder aufzunehmenden Wirkleistung bestimmt, und der maximal zulässige Sollwert der abzugebenden oder aufzunehmenden Blindleistung wird in Abhängigkeit des Sollwertes der abzugebenden oder aufzunehmenden Wirkleistung bestimmt. Bei Angabe einer Priorität Blindleistung wird zuerst der maximal zulässige Sollwert der abzugebenden oder aufzunehmenden Blindleistung bestimmt und der maximal zulässige Sollwert der abzugebenden oder aufzunehmenden Wirkleistung wird in

Abhängigkeit des maximal zulässigen Sollwertes der abzugebenden oder aufzunehmenden Blindleistung bestimmt.

Bei Angabe einer Priorität Wirkleistung wird vorrangig Wirkleistung produziert, das heißt die Blindleistung wird zuerst reduziert. Diese Priorität wird z.B. zur Triebstrangdämpfung vorgegeben. Bei Angabe einer Priorität Blindleistung wird vorrangig Blindleistung produziert, das heißt die Wirkleistung wird bei zu hohem Strom zuerst reduziert. Eine Priorität Blindleistung wird z. B. zur Spannungsstützung angegeben.

Die Angabe einer Priorität Wirk- oder Blindleistung ermöglicht in vorteilhafter Weise die Anpassung der Anlage mit doppeltgespeister Asynchronmaschine an die jeweiligen Bedingungen.

Gemäß einer weiteren bevorzugten Ausführungsform der vorliegenden Erfindung wird mittels eines vereinfachten Modells der doppeltgespeisten Asynchronmaschine aus dem maximal zulässigen Strom eine maximal zulässige Scheinleistung ermittelt.

Zum thermischen Schutz der doppeltgespeisten Asynchronmaschine und des dazugehörigen Umrichters ist die Begrenzung des Betrages des Stromes erforderlich. Es ist dabei unerheblich, ob es sich um einen Wirk- oder um einen Blindstrom handelt. Damit stellt der maximal zulässige Strom einen Scheinstrom dar. Es ist somit besonders einfach, unter Verwendung eines vereinfachten Modells aus dem maximal zulässigen Scheinstrom eine maximal zulässige Scheinleistung zu ermitteln. Eine solche Ausführungsform ist besonders universell. Sie ist unabhängig davon anwendbar, ob eine Priorität Wirkleistung oder eine Priorität Blindleistung angegeben wird, oder ob ein bestimmtes Verhältnis von Wirk- und Blindleistung, das heißt ein Leistungsfaktor, vorgegeben wird.

Gemäß einer weiteren bevorzugten Ausführungsform der vorliegenden Erfindung wird bei Angabe einer Priorität Wirkleistung der maximal zulässige Sollwert der abzugebenden oder aufzunehmenden Wirkleistung aus der maximal zulässigen Scheinleistung und einer Korrekturwirkleistung bestimmt, und der maximal zulässige Sollwert der abzugebenden oder aufzunehmenden Blindleistung wird aus dem Istwert der abgegebenen oder aufgenommenen Wirkleistung, der Korrekturwirkleistung und einer Korrekturblindleistung bestimmt.

Die maximal zulässige Scheinleistung wird mittels eines vereinfachten Modells bestimmt. Aus diesem Grunde kann in der Realität die maximal zulässige Scheinleistung sowohl nach oben oder unten abweichen. Deshalb sollte bei Angabe einer Priorität Wirkleistung der maximal zulässige Sollwert der abzugebenden oder aufzunehmenden Wirkleistung nicht allein aus maximal zulässigen Scheinleistung ermittelt werden, vielmehr ist es besonders vorteilhaft, die maximal zulässige Scheinleistung mit einer Korrekturwirkleistung zu beaufschlagen. Bei Angabe einer Priorität Wirkleistung wird nun zur optimalen Ausnutzung der Anlage der maximal zulässige Sollwert der abzugebenden oder aufzunehmenden Blindleistung in vorteilhafter Weise so bestimmt, dass unter Berücksichtung der Korrekturwerte für Wirk- und Blindleistung die maximal zulässige Scheinleistung nicht überschritten wird. Insofern wird klar, dass zur Ermittlung des maximal zulässigen Sollwertes der abgegebenen oder aufgenommenen Blindleistung der Istwert der abzugebenden oder aufzunehmenden Wirkleistung berücksichtigt wird.

Gemäß einer weiteren bevorzugten Ausführungsform der vorliegenden Erfindung wird bei Angabe einer Priorität Blindleistung der maximal zulässige Sollwert der abzugebenden oder aufzunehmenden Blindleistung aus der maximal zulässigen Scheinleistung und einer Korrekturblindleistung bestimmt und der maximal zulässige Sollwert der abzugebenden oder aufzunehmenden Wirkleistung wird aus dem Istwert der abgegebenen oder aufgenommenen Blindleistung, der Korrekturblindleistung und einer Korrekturwirkleistung bestimmt.

Gemäß einer weiteren bevorzugten Ausführungsform der vorliegenden Erfindung wird die Korrekturwirkleistung mittels eines Adaptionsgesetzes aus dem Istwert und einem Näherungswert für die aufgenommene oder abgegebene Wirkleistung bestimmt, wobei der Näherungswert aus der Summe der rückgekoppelten Korrekturwirkleistung und einer Wirkleistung, die mittels des vereinfachten Modells der doppeltgespeisten Asynchronmaschine ermittelt wird, besteht.

Gemäß einer weiteren bevorzugten Ausführungsform der vorliegenden Erfindung wird die Korrekturblindleistung mittels eines Adaptionsgesetzes aus dem Istwert und einem Näherungswert für die aufgenommene oder abgegebene Blindleistung bestimmt, wobei der Näherungswert aus der Summe der rückgekoppelten Korrekturblindleistung und einer Blindleistung, die mittels des vereinfachten Modells der doppeltgespeisten Asynchronmaschine ermittelt wird, besteht.

Die Ermittlung der Korrekturwerte für Wirk- und Blindleistung erfolgt also vorzugsweise mit einem Beobachter. Der Beobachter besteht aus einem einfachen Modell mit einer geeigneten Rückführung, die dafür sorgt, dass die Näherungswerte mit den gemessenen Systemgrößen in Übereinstimmung gebracht werden. Diese Übereinstimmung wird anhand eines Adaptionsgesetzes erreicht. Das Adaptionsgesetz muss so gewählt werden, das der Adaptionsvorgang stabil erfolgt. Eine einfache Umsetzung für ein Adaptionsgesetz ist die Auswertung der Differenz aus Näherungswert und Istwert durch einen Regler oder einen Filter. Die Systemgrößen des Beobachters sind Wirk- und Blindleistung. Das vereinfachte Modell berechnet aus dem Istwert des zu begrenzenden Stromes und der Spannung eine Modellwirk- und -blindleistung. Die Rückführung addiert hierzu einen Korrekturwert für Wirkleistung oder Blindleistung derart, dass diese Summe in Übereinstimmung mit der zu regelnden abzugebenden oder aufzunehmenden Wirk- und Blindleistung gebracht wird.

Im Allgemeinen wird davon ausgegangen, dass die doppeltgespeiste Asynchronmaschine an einem symmetrischen Dreiphasennetz betrieben wird. Dies ist in der Praxis jedoch nicht immer gegeben. Durch Unsymmetrien tritt in Spannungen und Strömen neben dem Mitsystem auch ein Gegensystem auf. Die gemessenen Ströme und Spannungen, die für die Regelung der abzugebenden oder aufzunehmenden Wirk- und Blindleistung oder zur Durchführung der Strombegrenzung erforderlich sind, können mit Hilfe bekannter Verfahren in Mit- und Gegensystem zerlegt werden. Solche Verfahren können z.B. der Dissertation von H. Wrede, "Beiträge zur Erhöhung von Versorgungssicherheit und Spannungsqualität in der Übertragung und Verteilung elektrischer Energie durch leistungselektronische Betriebsmittel", erschienen 2004 im Shaker Verlag, entnommen werden.

Die Gegensystemkomponente des Stromes führt zu einer zusätzlichen thermischen Belastung, so dass gemäß einer weiteren bevorzugten Ausführungsform der vorliegenden Erfindung die maximal zulässige Scheinleistung aus Mitsystemgrößen bestimmt wird, und die maximal zulässige Mitsystemkomponente des Stromes durch Verminderung des maximal zulässigen Stromes um die Gegensystemkomponente des Strom-Istwertes bestimmt wird.

Gemäß einer weiteren bevorzugten Ausführungsform der vorliegenden Erfindung wird anstelle des Istwertes der abgegebenen oder aufgenommenen Wirkleistung der Istwert der abgegeben oder aufgenommenen Mitsystemwirkleistung und anstelle des Istwertes der abgegebenen oder aufgenommenen Blindleistung der Istwert der abgegeben oder aufgenommenen Mitsystemblindleistung verwendet.

Die Gesamtleistung der Grundschwingungsanteile für ein System ohne Sternpunkterdung setzt sich aus der Summe von vier Produkten zusammen, nämlich dem Produkt aus den Mitsystemkomponenten von Strom und Spannung, dem Produkt aus den Gegensystemkomponenten von Strom und Spannung, dem Produkt aus der Mitsystemkomponente der Spannung und der Gegensystemkomponente des Stromes sowie dem Produkt aus der Gegensystemkomponente der Spannung und der Gegensystemkomponente des Stromes. Insbesondere die Produkte aus Mit- und Gegensystemkomponenten können bei der Leistungsregelung und Strombegrenzung zu Problemen führen, da sich hieraus Wechselleistungen ergeben. Bei einer Grundschwingungsfrequenz von 50 Hz haben diese Wechselleistungen eine Frequenz von 100 Hz. Die Produkte, die nur aus Gegensystem- bzw. Mitsystemkomponenten gebildet werden, ergeben dagegen im stationären Fall Gleichgrößen. Die Mitsystemleistung wird berechnet, indem die Gesamtleistung um die Produkte aus Mit- und Gegensystemkomponenten und dem Produkt aus den Gegensystemkomponenten reduziert wird.

Gemäß einer weiteren bevorzugten Ausführungsform der vorliegenden Erfindung werden zur Ermittlung der Wirkleistung und der Blindleistung mittels des vereinfachten Modells der doppeltgespeisten Asynchronmaschine Mitsystemgrößen verwendet.

Gemäß einer weiteren bevorzugten Ausführungsform der vorliegenden Erfindung wird der Rotorstrom der doppeltgespeisten Asynchronmaschine begrenzt.

Gemäß einer weiteren bevorzugten Ausführungsform der vorliegenden Erfindung wird der Statorstrom der doppeltgespeisten Asynchronmaschine begrenzt.

Gemäß einer weiteren bevorzugten Ausführungsform der vorliegenden Erfindung wird die Wirk- und Blindleistung des Stators der doppeltgespeisten Asynchronmaschine geregelt.

Gemäß einer weiteren bevorzugten Ausführungsform der vorliegenden Erfindung wird die Wirk- und Blindleistung des Netzes, an das die doppeltgespeiste Asynchronmaschine angeschlossen ist, geregelt.

Zur Lösung der Aufgabe wird ferner eine Vorrichtung zur Regelung der abgegebenen oder aufgenommenen Wirk- und Blindleistung einer doppeltgespeisten Asynchronmaschine vorgeschlagen, wobei die Vorrichtung Mittel zur Begrenzung eines Stromes der doppeltgespeisten Asynchronmaschine umfasst, **dadurch gekennzeichnet, dass** durch die Mittel während des Betriebes der doppeltgespeisten Asynchronmaschine ein maximal zulässiger Sollwert der abzugebenden oder aufzunehmenden Wirkleistung und ein maximal zulässiger Sollwert der abzugebenden oder aufzunehmenden Blindleistung anhand eines Modells der Asynchronmaschine aus einem maximal zulässigen Strom derart bestimmt werden, dass dieser nicht überschritten wird.

Die Vorrichtung gemäß der vorliegenden Erfindung kann beispielsweise ein Steuergerät zur Ansteuerung des Umrichters sein, das mit Schnittstellen zur Aufnahme von Messwerten und Sollwertvorgaben ausgestattet ist und einen oder mehrere Mikrocontroller zur Auswertung der Schnittstellensignale und Ausführung der Regelung aufweist.

Gemäß der Erfindung umfasst die Vorrichtung Mittel zur Angabe einer Priorität, wobei bei Angabe einer Priorität Wirkleistung zuerst der maximal zulässige Sollwert der abzugebenden oder aufzunehmenden Wirkleistung und der maximal zulässige Sollwert der abzugebenden oder aufzunehmenden Blindleistung in Abhängigkeit des Sollwertes der abzugebenden oder aufzunehmenden Wirkleistung durch die Mittel bestimmt wird, und wobei bei Angabe einer Priorität Blindleistung zuerst der maximal zulässige Sollwert der abzugebenden oder aufzunehmenden Blindleistung und der maximal zulässige Sollwert der abzugebenden oder aufzunehmenden Wirkleistung in Abhängigkeit des maximal zulässigen Sollwertes der abzugebenden oder aufzunehmenden Blindleistung durch die Mittel bestimmt wird.

Gemäß einer weiteren bevorzugten Ausführungsform der vorliegenden Erfindung ermitteln die Mittel unter Verwendung eines vereinfachten Modells der doppeltgespeisten Asynchronmaschine aus dem maximal zulässigen Strom eine maximal zulässige Scheinleistung.

Gemäß einer weiteren bevorzugten Ausführungsform der vorliegenden Erfindung wird bei Angabe einer Priorität Wirkleistung der maximal zulässige Sollwert der abzugebenden oder aufzunehmenden Wirkleistung aus der maximal zulässigen Scheinleistung und einer Korrekturwirkleistung durch die Mittel bestimmt und der maximal zulässige Sollwert der abzugebenden oder aufzunehmenden Blindleistung wird aus dem Istwert der abgegebenen oder aufgenommenen Wirkleistung, der Korrekturwirkleistung und einer Korrekturblindleistung durch die Mittel bestimmt.

Gemäß einer weiteren bevorzugten Ausführungsform der vorliegenden Erfindung wird bei Angabe einer Priorität Blindleistung der maximal zulässige Sollwert der abzugebenden oder aufzunehmenden Blindleistung aus der maximal zulässigen Scheinleistung und einer Korrekturblindleistung durch die Mittel bestimmt, und der maximal zulässige Sollwert der abzugebenden oder aufzunehmenden Wirkleistung wird aus dem Istwert der abgegebenen oder aufgenommenen Blindleistung, der Korrekturblindleistung und einer Korrekturwirkleistung durch die Mittel bestimmt.

Gemäß einer weiteren bevorzugten Ausführungsform der vorliegenden Erfindung wird die Korrekturwirkleistung mittels einer Adaptionseinheit aus dem Istwert und einem Näherungswert für die aufgenommene oder abgegebene Wirkleistung bestimmt, wobei der Näherungswert aus der Summe der rückgekoppelten Korrekturwirkleistung und einer Wirkleistung, die durch die Mittel unter Verwendung des vereinfachten Modells der doppeltgespeisten Asynchronmaschine berechnet wird, besteht.

Gemäß einer weiteren bevorzugten Ausführungsform der vorliegenden Erfindung wird die Korrekturblindleistung mittels einer Adaptionseinheit aus dem Istwert und einem Näherungswert für die aufgenommene oder abgegebene Blindleistung bestimmt, wobei der Näherungswert aus der Summe der rückgekoppelten Korrekturblindleistung und einer Blindleistung, die durch die Mittel unter Verwendung des vereinfachten Modells der doppeltgespeisten Asynchronmaschine berechnet wird, besteht.

Gemäß einer weiteren bevorzugten Ausführungsform der vorliegenden Erfindung wird die maximal zulässige Scheinleistung durch die Mittel aus Mitsystemgrößen bestimmt und die maximal zulässige Mitsystemkomponente des Stromes wird durch Mittel zur Verminderung des maximal zulässigen Stromes um die Gegensystemkomponente des Strom-Istwertes bestimmt.

Gemäß einer weiteren bevorzugten Ausführungsform der vorliegenden Erfindung verwenden die Mittel anstelle des Istwertes der abgegebenen oder aufgenommenen Wirkleistung den Istwert der abgegeben oder aufgenommenen Mitsystemwirkleistung und anstelle des Istwertes der abgegebenen oder aufgenommenen Blindleistung den Istwert der abgegeben oder aufgenommenen Mitsystemblindleistung. Gemäß einer weiteren bevorzugten Ausführungsform der vorliegenden Erfindung verwenden die Mittel zur Berechnung der Wirkleistung und der Blindleistung unter Verwendung des vereinfachten Modells der doppeltgespeisten Asynchronmaschine Mitsystemgrößen.

Gemäß einer weiteren bevorzugten Ausführungsform der vorliegenden Erfindung wird der Rotorstrom der doppeltgespeisten Asynchronmaschine begrenzt.

Gemäß einer weiteren bevorzugten Ausführungsform der vorliegenden Erfindung wird der Statorstrom der doppeltgespeisten Asynchronmaschine begrenzt.

Gemäß einer weiteren bevorzugten Ausführungsform der vorliegenden Erfindung wird die Wirk- und Blindleistung des Stators der doppeltgespeisten Asynchronmaschine geregelt.

Gemäß einer weiteren bevorzugten Ausführungsform der vorliegenden Erfindung wird die Wirk- und Blindleistung des Netzes, an das die doppeltgespeiste Asynchronmaschine angeschlossen ist, geregelt.

Im Folgenden wird ein Ausführungsbeispiel der vorliegenden Erfindung unter Bezugnahme auf die Zeichnungen näher erläutert.

Es zeigen:

Fig. 1: eine schematische Darstellung einer Regelstruktur zur Regelung der abge- gebenen oder aufgenommenen Wirk- und Blindleistung der doppeltgespeis- ten Asynchronmaschine ohne unterlagerte Stromregler;

Fig. 2: eine schematische Darstellung eines erfindungsgemäßen Verfahrens zur Bestimmung der maximal zulässigen Sollwerte der abzugebenden oder auf- zunehmenden Wirk- und Blindleistung;

Fig. 3: eine schematische Darstellung eines Verfahrens zur Ermittlung der Korrek- turwirkleistung;

Fig. 4: eine schematische Darstellung eines Verfahrens zur Ermittlung der Korrek- turblindleistung;

Die vorliegende Erfindung betrifft die Regelung der abgegebenen oder aufgenommenen Wirk- und Blindleistung einer doppeltgespeisten Asynchronmaschine, wobei der Strom der Maschine begrenzt wird. Im Folgenden wird die Erfindung am Beispiel der Begrenzung des Rotorstromes einer doppeltgespeisten Asynchronmaschine, deren an das Netz abgegebene oder aufgenommene Wirk- und Blindleistung geregelt wird, erläutert.

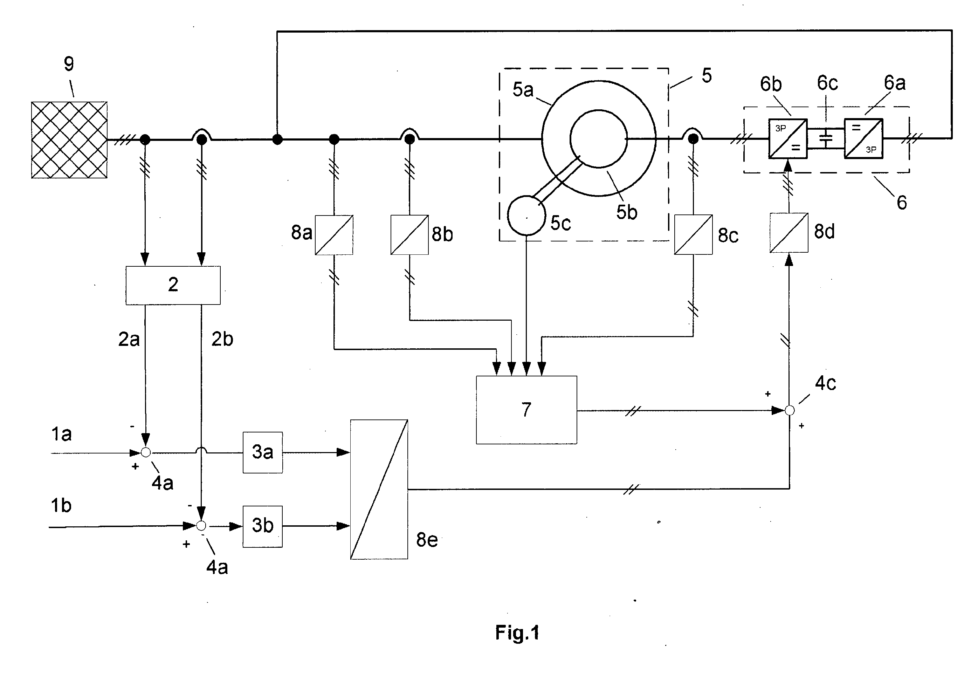

Fig. 1 zeigt die schematische Darstellung einer doppeltgespeisten Asynchronmaschine mit der dazugehörigen Regelungstechnik. Die Asynchronmaschine 5 besteht aus einem Stator 5a und einem Rotor 5b. Des Weiteren weist die Asynchronmaschine einen Lagegeber 5c auf. Zum Betrieb der doppeltgespeisten Asynchronmaschine ist außerdem ein Umrichter 6 erforderlich. In diesem Ausführungsbeispiel besteht der Umrichter aus einem netzseitigen Umrichter 6a und einem maschinenseitigen Umrichter 6b. Der netzseitige und der maschinenseitige Umrichter sind durch einen Gleichspannungszwischenkreis 6c miteinander verbunden. Der maschinenseitige Umrichter 6b ist über Schleifringe mit dem Rotor 5b der Asynchronmaschine verbunden. Der Stator 5a der Maschine ist mit einem elektrischen Netz 9 und dem netzseitigen Umrichter 6a verbunden. Der Lagegeber 5c beinhaltet eine nicht dargestellte Auswerteeinheit. Dadurch können sowohl die Rotorlage als auch die Rotordrehzahl für die Regelung zur Verfügung gestellt werden. In alternativen Ausführungsformen können Rotorlage und Rotordrehzahl auch aus den elektrischen Größen der Asynchronmaschine bestimmt werden, das heißt ohne Verwendung eines mechanischen Sensors.

Der Regelung der doppeltgespeisten Asynchronmaschine werden ein Sollwert für die abzugebende oder aufzunehmende Wirkleistung 1a, im folgenden kurz Wirkleistungssollwert genannt, und ein Sollwert für die abzugebende oder aufzunehmende Blindleistung 1b, im folgenden kurz Blindleistungssollwert genannt, übergeben. In der in Fig. 1 dargestellten schematischen Darstellung handelt es sich um Sollwerte für die an das Netz abgegebene oder aufgenommene Wirk- und Blindleistung. Mit dem Leistungsberechungsmodul 2 werden aus den Istwerten der Netzströme und der Netzspannungen der Istwert der Netzwirkleistung 2a und der Istwert der Netzblindleistung 2b bestimmt. Der Wirkleistungssollwert 1a und der negative Wirkleistungsistwert 2a werden dem Addierer 4a zugeführt und ergeben eine Sollgrößenabweichung. Entsprechend wird der Blindleistungssollwert 1b und der negative Blindleistungsistwert 2b zur Bestimmung einer Sollgrößenabweichung dem Addierer 4b zugeführt. Die entsprechenden Sollgrößenabweichungen werden dem Wirkleistungsregler 3a und dem Blindleistungsregler 3b zugeführt.

Ein wesentlicher Bestandteil der Leistungsregelung ohne unterlagerte Stromregler ist die modellbasierte Rückführung. Diese wird durch die Rückführungseinheit 7 berechnet. Der Rückführungseinheit werden die Statorspannung, der Statorstrom und der Rotorstrom zugeführt, wobei die dreiphasigen gemessen Größen mittels der Transformationseinheiten 8a-c in ein zweiphasiges Koordinatensystem transformiert werden. Das zweiphasige Koordinatensystem kann sowohl ein wicklungsfestes als auch ein rotierendes Koordinatensystem sein. Je nach Art der Rückführung ist nur ein Teil dieser Größen erforderlich. Weiterhin ist für die Rückführung im Allgemeinen die Drehzahl der Maschine erforderlich. Dazu wird der Rückführungseinheit 7 die Drehzahl von der Auswerteeinheit des Lagegebers übergeben. Die Ausgänge der Leistungsregler 3a und 3b werden durch den Addierer 4c mit dem Ausgang der Rückführungseinheit beaufschlagt. Je nach Art der verwendeten Koordinatensysteme werden die Ausgänge der Leistungsregler zuvor mittels der Rückführungseinheit 8e in das entsprechende Koordinatensystem transformiert. Die Summe des Addierers 4c bildet nach Transformation in dreiphasige natürliche Koordinaten mittels der Transformationseinheit 8d das Stellsignal für den maschinenseitigen Umrichter.

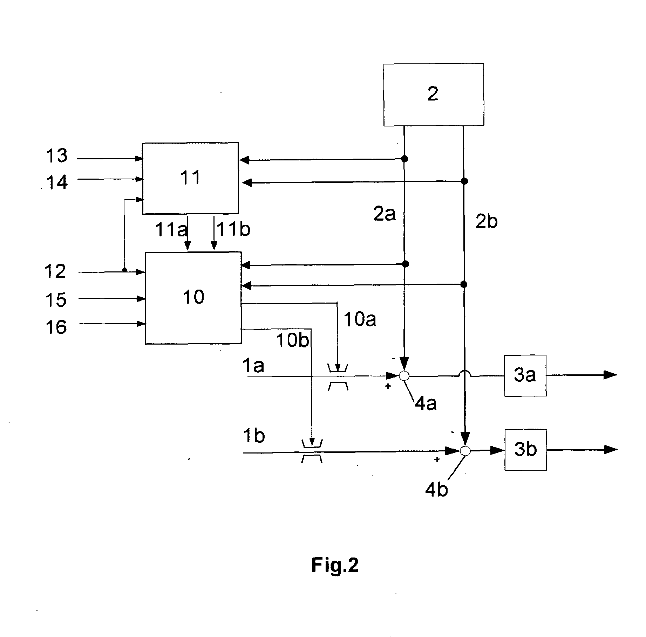

Fig. 2 zeigt eine schematische Darstellung eines erfindungsgemäßen Verfahrens zur Bestimmung der maximal zulässigen Sollwerte der abgegebenen oder aufgenommenen Wirk- und Blindleistung. Der Wirkleistungssollwert 1a wird dabei auf den maximal zulässigen Sollwert der abgegebenen oder aufgenommenen Wirkleistung 10a begrenzt. Der begrenzte Wirkleistungssollwert wird dann, wie auch in Fig. 1 gezeigt, mittels des Addierers 4a mit dem negativen Istwert der Wirkleistung 2a beaufschlagt und dem Wirkleistungsregler 3a zugeführt. Entsprechend wird der Blindleistungssollwert 1 b auf den maximal zulässigen Sollwert der abgegebenen oder aufgenommenen Blindleistung 10b begrenzt, mittels des Addierers 4b mit dem negativen Istwert der Blindleistung beaufschlagt und dem Blindleistungsregler 3b zugeführt.

Die maximal zulässigen Sollwerte für Wirk- und Blindleistung werden mittels der Strombegrenzungseinheit 10 ermittelt. Der Strombegrenzungseinheit 10 kann eine Priorität Wirkleistung oder eine Priorität Blindleistung vorgegeben werden. Unabhängig von der Priorität wird mittels der Strombegrenzungseinheit eine maximal zulässige Scheinleistung $S_{max}$ gemäß Gleichung (1) berechnet.

$$S_{max} = \sqrt{3} \cdot U_{Gen} \cdot w_{21} \cdot I_{Rot.max} \cdot \qquad (1)$$

Dabei ist $U_{Gen}$ der Betrag der Generatorspannung 15 und $I_{Rot,max}$ der maximal zulässige Rotorstrom 16. Das effektive Übersetzungsverhältnis $w_{21}$ ist ein Parameter des vereinfachten Modells.

Bei Angabe einer Priorität Wirkleistung berechnet sich der maximal zulässige Sollwert der abgegebenen oder aufgenommenen Wirkleistung 10a $P_{max}$ aus Gleichung (2) und der maximal zulässige Sollwert der abgegebenen oder aufgenommenen Blindleistung 10b $Q_{max}$ aus Gleichung (3).

$$P_{max} = S_{max} \cdot (1 - s) + P_0 \qquad (2)$$

$$Q_{max} = \frac{\sqrt{(P_{max} - P_0)^2 - (P_{ist} - P_0)^2}}{(1 - s)} + Q_0 \qquad (3)$$

Dabei ist $P_0$ die Korrekturwirkleistung 11a und $Q_0$ die Korrekturblindleistung 11b, die von der Korrektureinheit 11 an die Strombegrenzungseinheit 10 übergeben werden. Der Istwert der abgegebenen oder aufgenommenen Wirkleistung 2a $P_{ist}$ wird vom Leistungsberechnungsmodul 2 an die Strombegrenzungseinheit 10 übergeben. $\overline{s}$ ist der Schlupf 12, der der Strombegrenzungseinheit ebenfalls zur Verfügung gestellt werden muss.

Bei Angabe einer Priorität Blindleistung berechnet sich der maximal zulässige Sollwert der abgegebenen oder aufgenommenen Blindleistung 10b $Q_{max}$ aus Gleichung (4) und der maximal zulässige Sollwert der abgegebenen oder aufgenommenen Wirkleistung 10a $P_{max}$ aus Gleichung (5).

$$Q_{max} = S_{max} + Q_0 \qquad (4)$$

$$P_{max} = \sqrt{(Q_{max} - Q_0)^2 - (Q_{ist} - Q_0)^2} \cdot (1 - s) + P_0 \qquad (5)$$

Zu den bereits erläuterten Größen kommt hier noch der Istwert der abgegebenen oder aufgenommenen Blindleistung 2b $Q_{ist}$ hinzu, der analog zum Wirkleistungsistwert vom Leistungsberechnungsmodul 2 an die Strombegrenzungseinheit 10 übergeben wird.

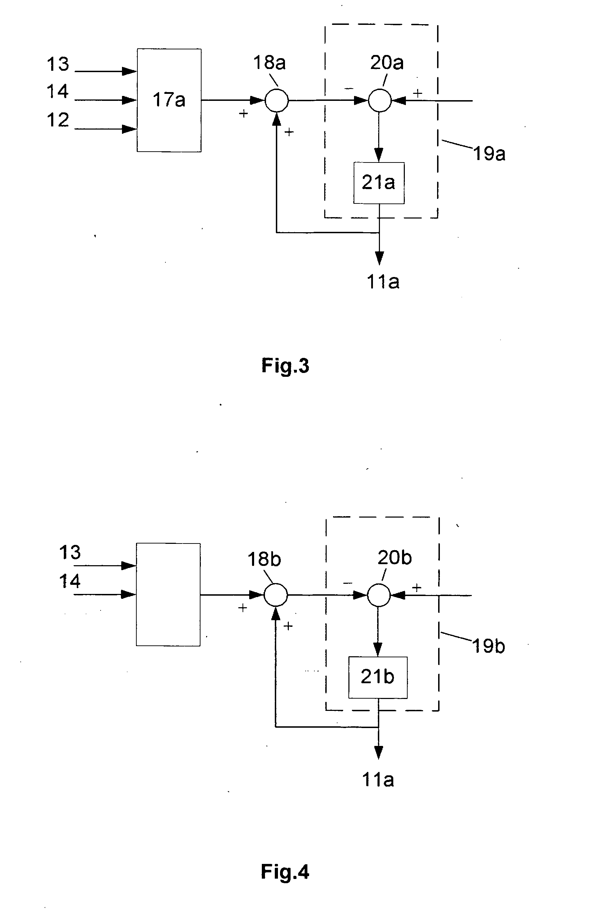

Der Korrektureinheit 11 werden zur Ermittlung der Korrekturwirkleistung 11a und der Korrekturblindleistung 11 b die Istwerte der abgegebenen oder aufgenommenen Wirkleistung 2a und Blindleistung 2b übergeben. Des Weiteren werden der Korrektureinheit der Schlupf 12 und die Istwerte der Generatorspannung 13 und der Rotorstromes 14 zugeführt. Die Funktionsweise der Korrektureinheit ist in den Fig. 3 und Fig. 4 genauer dargestellt.

Fig. 3 zeigt eine schematische Darstellung eines Verfahrens zur Ermittlung der Korrekturwirkleistung 11a. Der Berechnungseinheit 17a werden die Generatorspannung 13, der Rotorstrom 14 und der Schlupf 12 zugeführt. In dem beschriebenen Ausführungsbeispiel werden die Generatorspannung und der Rotorstrom in einen wicklungsfesten zweiphasigen Koordinatensystem dargestellt. Die Generatorspannung wird somit durch die Komponenten, $U_{Gen,\alpha}$ und $U_{Gen,\beta}$ beschrieben.

Der Rotorstrom besteht aus den Komponenten $I_{Rot,\beta}$ und $I_{Rot,\beta}$. Damit berechnet sich die Wirkleistung $P_{Modell}$ aus dem vereinfachten Modell.

$$P_{Modell} = (1-s) \cdot w_{21} \cdot (U_{Gen,\alpha} \cdot I_{Rot,\alpha} + U_{Gen,\beta} \cdot I_{Rot,\beta}) \qquad (6)$$

Der Modellwirkleistung $P_{Modell}$ bildet den Ausgang der Berechnungseinheit 17a. Die Modellwirkleistung wird mittels des Addierers 18a mit der rückgekoppelten Korrekturwirkleistung 11a beaufschlagt und ergibt einen Näherungswert für die aufgenommene oder abgegebene Wirkleistung. Der Näherungswert und der Wirkleistungsistwert 2a werden der Adaptionseinheit 19a zugeführt und mittels eines Adaptionsgesetzes die Korrekturwirkleistung 11a bestimmt. Der Adaptionsvorgang wird durch einen Addierer 20a und einen Regler 21 a realisiert. Der Addierer 20a ermittelt die Eingangsgröße für den Regler aus dem negativen Näherungswert und dem Wirkleistungsistwert. Die Ausgangsgröße des Reglers 21a bildet die Korrekturwirkleistung 11a

Fig. 4 zeigt eine entsprechende schematische Darstellung eines Verfahrens zur Ermittlung der Korrekturblindleistung. Die Berechnungseinheit 17b ermittelt aus der Generatorspannung 13 und dem Rotorstrom 14 eine Modellblindleistung $Q_{Modell}$. In einem wicklungsfesten zweiphasigen Koordinatensystem berechnet sich die Modellblindleistung gemäß Gleichung (7).

$$Q_{Modell} = \cdot w_{21} \cdot (-U_{Gen,\alpha} \cdot I_{Rot,\beta} + U_{Gen,\beta} \cdot I_{Rot,\alpha}) \qquad (7)$$

Durch den Addierer 18b wird die Modellblindleistung mit dem der rückgekoppelten Korrekturblindleistung beaufschlagt und ergibt einen Näherungswert für die aufgenommene oder abgegebene Blindleistung. Der Addierer 20b ermittelt aus dem negativen Näherungswert und dem Blindleistungsistwert 2b eine Abweichung, die dem Regler 21 b zugeführt wird. Der Ausgang des Reglers ist die Korrekturblindleistung 11b. Der Addierer 20b und der Regler 21 b bilden die Adaptionseinheit 19b.

Das beschriebene Ausführungsbeispiel funktioniert zuverlässig nur bei Betrieb der doppeltgespeisten Asynchronmaschine an einem symmetrischen Dreiphasennetz. Es ist jedoch möglich, Unsymmetrien zu berücksichtigen. Dazu werden die Messgrößen in Mit- und Gegensystem zerlegt.

Der maximal zulässige Rotorstrom 16, der der Strombegrenzungseinheit 10 zur Verfügung gestellt wird, wird dann durch die maximal zulässige Mitsystemkomponente des Rotorstromes $I_{Rot,max,mit}$ ersetzt. Diese Mitsystemkomponente ergibt sich aus dem maximal zulässigen Rotorstrom $I_{Rot,max}$ und der Gegensystemkomponente des Rotorstrom-Istwertes $I_{Rot,gegen}$

$$I_{Rot,max,mit} = \sqrt{I_{Rot,max}{}^2 - I_{Rot,gegen}{}^2} \qquad (8)$$

Die Istwerte für die aufgenommene oder abgegebene Wirkleistung 2a und Blindleistung 2b werden sowohl für die Strombegrenzungseinheit 10 als auch für die Korrektureinheit 11 durch die Mitsystemkomponenten der Istwerte ersetzt.

Für die Berechnung der Modellwirk- und -blindleistung werden Mitsystemkomponenten von Generatorspannung und Rotorstrom verwandt.

$$P_{Modell} = (1-s) \cdot w_{21} \cdot (U_{Gen,\alpha,mit} \cdot I_{Rot,\alpha,mit} + U_{Gen,\beta,mit} \cdot I_{Rot,\beta,mit}) \qquad (9)$$

$$Q_{Modell} = \cdot \dot{w}_{21} \cdot (-U_{Gen,\alpha,mit} \cdot I_{Rot,\beta,mit} + U_{Gen,\beta,mit} \cdot I_{Rot,\alpha,mit}) \qquad (10)$$

Durch die beschriebene Erweiterung des erfindungsgemäßen Verfahrens ist das Schutzkonzept auch bei Unsymmetrien in dem elektrischen Netz einsetzbar.

Das Verfahren lässt sich analog auch zur Begrenzung des Statorstromes der doppeltgespeisten Asynchronmaschine verwenden. Des Weiteren ist es einsetzbar, wenn die Wirk- und Blindleistung des Stators geregelt wird.

**Patentansprüche**

1. Verfahren zur Begrenzung eines Stromes einer doppeltgespeisten Asynchronmaschine (5), bei der die abgegebene oder aufgenommene Wirk- sowie die abgegebene oder aufgenommene Blindleistung anhand vorgegebener Wirk- und Blindleistungssollwerte geregelt wird,
   wobei während des Betriebes der doppeltgespeisten Asynchronmaschine ein maximal zulässiger Sollwert der abzugebenden oder aufzunehmenden Wirkleistung (10a) und ein maximal zulässiger Sollwert der abzugebenden oder aufzunehmenden Blindleistung (10b) anhand eines Modells der Asynchronmaschine (5) aus dem vorgegebenen maximal zulässigen Strom (16) derart berechnet wird, dass dieser nicht überschritten wird,
   **dadurch gekennzeichnet, dass** die vorgegebenen Wirkleistungs- und Blindleistungssollwerte auf die berechneten maximal zulässigen Wirkleistungs- und Blindleistungssollwerte begrenzt werden, wobei
   bei Angabe einer Priorität Wirkleistung zuerst der maximal zulässige Sollwert der abzugebenden oder aufzunehmenden Wirkleistung (10a) bestimmt wird und der maximal zulässige Sollwert der abzugebenden oder aufzunehmenden Blindleistung (10b) in Abhängigkeit des Sollwertes der abzugebenden oder aufzunehmenden Wirkleistung bestimmt wird, und
   bei Angabe einer Priorität Blindleistung zuerst der maximal zulässige Sollwert der abzugebenden oder aufzunehmenden Blindleistung (10b) bestimmt wird und der maximal zulässige Sollwert der abzugebenden oder aufzunehmenden Wirkleistung (10a) in Abhängigkeit des maximal zulässigen Sollwertes der abzugebenden oder aufzunehmenden Blindleistung bestimmt wird.

2. Verfahren nach Anspruch 1, **dadurch gekennzeichnet, dass** bei der Berechnung der maximal zulässigen Sollwerte für die Wirk- und Blindleistung wenigstens der Istwert des zu begrenzenden Stromes zur Korrektur herangezogen wird.

3. Verfahren nach Anspruch 1 oder 2, **dadurch gekennzeichnet, dass** mittels eines vereinfachten Modells der doppeltgespeisten Asynchronmaschine (5) aus dem maximal.zulässigen Strom eine maximal zulässige Scheinleistung ermittelt wird.

4. Verfahren nach einem der Ansprüche 1 bis 3, **dadurch gekennzeichnet, dass** bei Angabe einer Priorität Wirkleistung der maximal zulässige Sollwert der abzugebenden oder aufzunehmenden Wirkleistung (10a) aus der maximal zulässigen Scheinleistung und einer Korrekturwirkleistung (11a) bestimmt wird, und der maximal zulässige Sollwert der abzugebenden oder aufzunehmenden Blindleistung (10b) aus dem Istwert der abgegebenen oder aufgenommenen Wirkleistung (2a), der Korrekturwirkleistung (11a) und einer Korrekturblindleistung (11 b) bestimmt wird.

5. Verfahren nach einem der Ansprüche 1 bis 3, **dadurch gekennzeichnet, dass** bei Angabe einer Priorität Blindleistung der maximal zulässige Sollwert der abzugebenden oder aufzunehmenden Blindleistung (10b) aus der maximal zulässigen Scheinleistung und einer Korrekturblindleistung (11 b) bestimmt wird, und der maximal zulässige Sollwert der abzugebenden oder aufzunehmenden Wirkleistung (11a) aus dem Istwert der abgegebenen oder aufgenommenen Blindleistung (2b), der Korrekturblindleistung (11 b) und einer Korrekturwirkleistung (11a) bestimmt wird.

6. Verfahren nach Anspruch 4 oder 5, **dadurch gekennzeichnet, dass** die Korrekturwirkleistung (11a) mittels eines Adaptionsgesetzes aus dem Istwert (2a) und einem Näherungswert für die abgegebene oder aufgenommene Wirkleistung bestimmt wird, wobei der Näherungswert aus der Summe der rückgekoppelten Korrekturwirkleistung (11a) und einer Wirkleistung, die mittels des vereinfachten Modells der doppeltgespeisten Asynchronmaschine ermittelt wird, besteht.

7. Verfahren nach Anspruch 4 oder 5, **dadurch gekennzeichnet, dass** die Korrekturblindleistung (11 b) mittels eines Adaptionsgesetzes aus dem Istwert (2b) und einem Näherungswert für die abgegebene oder aufgenommene Blindleistung bestimmt wird, wobei der Näherungswert aus der Summe der rückgekoppelten Korrekturblindleistung (11 b) und einer Blindleistung, die mittels des vereinfachten Modells der doppeltgespeisten Asynchronmaschine ermittelt wird, besteht.

8. Verfahren nach einem der Ansprüche 3 bis 7, **dadurch gekennzeichnet, dass** die maximal zulässige Scheinleistung aus Mitsystemgrößen bestimmt wird, und die maximal zulässige Mitsystemkomponente des Stromes durch Verminderung des maximal zulässigen Stromes um die Gegensystemkomponente des Strom-Istwertes bestimmt wird.

9. Verfahren nach einem der Ansprüche 4 bis 7, **dadurch gekennzeichnet, dass** anstelle des Istwertes der abgegebenen oder aufgenommenen Wirkleistung der Istwert der abgegeben oder aufgenommenen Mitsystemwirkleistung und anstelle des Istwertes der abgegebenen oder aufgenommenen Blindleistung der Istwert der abgegeben oder aufgenommenen Mitsystemblindleistung verwendet wird.

10. Verfahren nach einem der Ansprüche 6 oder 7, **dadurch gekennzeichnet, dass** zur Ermittlung der Wirkleistung und der Blindleistung mittels des vereinfachten Modells der doppeltgespeisten Asynchronmaschine Mitsystemgrößen verwendet werden.

11. Verfahren nach einen der Ansprüche 1 bis 10, **dadurch gekennzeichnet, dass** der Rotorstrom der doppeltgespeisten Asynchronmaschine begrenzt wird.

12. Verfahren nach einen der Ansprüche 1 bis 10, **dadurch gekennzeichnet, dass** der Statorstrom der doppeltgespeisten Asynchronmaschine begrenzt wird.

13. Verfahren nach einem der Ansprüche 1 bis 12, **dadurch gekennzeichnet, dass** die Wirk- und Blindleistung des Stators der doppeltgespeisten Asynchronmaschine oder die Wirk- und Blindleistung des Netzes, an das die doppeltgespeiste Asynchronmaschine angeschlossen ist, geregelt wird.

14. Vorrichtung zur Regelung der abgegebenen oder aufgenommenen Wirkleistung und der abgegebenen oder aufgenommenen Blindleistung einer doppeltgespeisten Asynchronmaschine (5), wobei die Vorrichtung Mittel zur Begrenzung eines Stromes der doppeltgespeisten Asynchronmaschine umfasst, wobei durch die Mittel während des Betriebes der doppeltgespeisten Asynchronmaschine ein maximal zulässiger Sollwert der abzugebenden oder aufzunehmenden Wirkleistung (10a) und ein maximal zulässiger Sollwert der abzugebenden oder aufzunehmenden Blindleistung (10b) derart anhand eines mathematischen Modells der Asynchronmaschine aus dem vorgegebenen maximal zulässigen Strom bestimmt werden, dass der maximal zulässige Strom (16) nicht überschritten wird, **dadurch gekennzeichnet, dass**
die Mittel dahingehend ausgebildet sind, die vorgegebenen Wirkleistungs-und Blindleistungssollwerte auf die berechneten maximal zulässigen Wirkleistungs- und Blindleistungssollwerte zu begrenzen,
dass die Vorrichtung Mittel zur Angabe einer Priorität umfasst,
dass bei Angabe einer Priorität Wirkleistung zuerst der maximal zulässige Sollwert der abzugebenden oder aufzunehmenden Wirkleistung (10a) durch die Mittel bestimmt wird und der maximal zulässige Sollwert der abzugebenden oder aufzunehmenden Blindleistung (10b) in Abhängigkeit des Sollwertes der abzugebenden oder aufzunehmenden Wirkleistung durch die Mittel bestimmt wird, und
dass bei Angabe einer Priorität Blindleistung zuerst der maximal zulässige Sollwert der abzugebenden oder aufzunehmenden Blindleistung (10b) durch die Mittel bestimmt wird und der maximal zulässige Sollwert der abzugebenden oder aufzunehmenden Wirkleistung (10a) in Abhängigkeit des maximal zulässigen Sollwertes der abzugebenden oder aufzunehmenden Blindleistung durch die Mittel bestimmt wird.

15. Vorrichtung nach Anspruch 14, **dadurch gekennzeichnet, dass** diese ferner zur Durchführung eines Verfahrens nach einem der Ansprüche 2 bis 13 ausgebildet ist.

## Claims

1. A method of limiting a current of a double-fed asynchronous machine (5) in which the output or input active power and the output or input reactive power is regulated on the basis of predetermined active and reactive power reference values,
wherein during operation of the double-fed asynchronous machine a maximum permissible reference value of the active power (10a) to be output or input and a maximum permissible reference value of the reactive power (10b) to be output or input is calculated on the basis of a model of the asynchronous machine (5) from the predetermined maximum permissible current (16) in such a way that same is not exceeded **characterised in that** the predetermined active power and reactive power reference values are limited to the calculated maximum permissible active power and reactive power reference values, wherein

when specifying an active power priority firstly the maximum permissible reference value of the active power (10a) to be output or input is determined and the maximum permissible reference value of the reactive power (10b) to be output or input is determined in dependence on the reference value of the active power to be output or input, and when specifying a reactive power priority firstly the maximum permissible reference value of the reactive power (10b) to be output or input is determined and the maximum permissible reference value of the active power (10a) to be output or input is determined in dependence on the maximum permissible reference value of the reactive power to be output or input.

2. A method according to claim 1 **characterised in that** in calculation of the maximum permissible reference values for the active and reactive power at least the actual value of the current to be limited is utilised for correction purposes.

3. A method according to claim 1 or claim 2 **characterised in that** a maximum permissible apparent power is ascertained by means of a simplified model of the double-fed asynchronous machine (5) from the maximum permissible current.

4. A method according to one of claims 1 to 3 **characterised in that** when specifying an active power priority the maximum permissible reference value of the active power (10a) to be output or input is determined from the maximum permissible apparent power and a correction active power (11a) and the maximum permissible reference value of the reactive power (10b) to be output or input is determined from the actual value of the output or input active power (2a), the correction active power (11a) and a correction reactive power (11b).

5. A method according to one of claims 1 to 3 **characterised in that** when specifying a reactive power priority the maximum permissible reference value of the reactive power (10b) to be output or input is determined from the maximum permissible apparent power and a correction reactive power (11b) and the maximum permissible reference value of the active power (11a) to be output or input is determined from the actual value of the output or input reactive power (2b), the correction reactive power (11) and a correction active power (11a).

6. A method according to claim 4 or claim 5 **characterised in that** the correction active power (11a) is determined by means of an adaption law from the actual value (2a) and an approximation value for the output or input active power, wherein the approximation value comprises the sum of the fed-back correction active power (11a) and an active power which is ascertained by means of the simplified model of the double-fed asynchronous machine.

7. A method according to claim 4 or claim 5 **characterised in that** the correction reactive power (11b) is determined by means of an adaption law from the actual value (2b) and an approximation value for the output or input reactive power, wherein the approximation value comprises the sum of the fed-back correction reactive power (11b) and an reactive power which is ascertained by means of the simplified model of the double-fed asynchronous machine.

8. A method according to one of claims 3 to 7 **characterised in that** the maximum permissible apparent power is determined from positive phase-sequence system parameters and the maximum permissible positive phase-sequence system component of the current is determined by reducing the maximum permissible current by the negative phase-sequence system component of the current actual value.

9. A method according to one of claims 4 to 7 **characterised in that** instead of the actual value of the output or input active power the actual value of the output or input positive phase-sequence system active power is used and instead of the actual value of the output or input reactive power the actual value of the output or input positive phase-sequence system reactive power is used.

10. A method according to one of claims 6 and 7 **characterised in that** positive phase-sequence system parameters are used for ascertaining the active power and the reactive power by means of the simplified model of the double-fed asynchronous machine.

11. A method according to one of claims 1 to 10 **characterised in that** the rotor current of the double-fed asynchronous machine is limited.

**12.** A method according to one of claims 1 to 10 **characterised in that** the stator current of the double-fed asynchronous machine is limited.

**13.** A method according to one of claims 1 to 12 **characterised in that** the active and reactive power of the stator of the double-fed asynchronous machine or the active and reactive power of the network to which the double-fed asynchronous machine is connected is regulated.

**14.** Apparatus for regulating the output or input active power and the output or input reactive power of a double-fed asynchronous machine (5), wherein the apparatus has means for limiting a current of the double-fed asynchronous machine, wherein during operation of the double-fed asynchronous machine a maximum permissible reference value of the active power (10a) to be output or input and a maximum permissible reference value of the reactive power (10b) to be output or input is determined by said means on the basis of a mathematical model of the asynchronous machine from the predetermined maximum permissible current in such a way that the maximum permissible current (16) is not exceeded, **characterised in that**

the means are adapted to limit the predetermined active power and reactive power reference values to the calculated maximum permissible active power and reactive power reference values

the apparatus includes means for specifying a priority,

when specifying an active power priority firstly the maximum permissible reference value of the active power (10a) to be output or input is determined by the means and the maximum permissible reference value of the reactive power (10b) to be output or input is determined by the means in dependence on the reference value of the active power to be output or input, and

when specifying a reactive power priority firstly the maximum permissible reference value of the reactive power (10b) to be output or input is determined by the means and the maximum permissible reference value of the active power (10a) to be output or input is determined by the means in dependence on the maximum permissible reference value of the reactive power to be output or input.

**15.** Apparatus according to claim 14 **characterised in that** it is further adapted to carry out a method according to one of claims 2 to 13.

**Revendications**

**1.** Procédé pour limiter un courant d'une machine asynchrone (5) à double alimentation, sur laquelle la puissance active délivrée ou absorbée et la puissance réactive délivrée ou absorbée sont réglées à l'aide de valeurs de consigne prédéfinies de puissance active et de puissance réactive,

une valeur de consigne maximale autorisée de la puissance active (10a) à délivrer ou à absorber et une valeur de consigne maximale autorisée de la puissance réactive (10b) à délivrer ou à absorber étant calculées, pendant le fonctionnement de la machine asynchrone à double alimentation, à l'aide d'un modèle de la machine asynchrone (5) à partir du courant (16) maximal autorisé et prédéfini de telle sorte que cette valeur ne soit pas dépassée,

**caractérisé en ce que** les valeurs de consigne prédéfinies de puissance active et de puissance réactive sont limitées aux valeurs de consigne maximales autorisées et calculées de puissance active et de puissance réactive, sachant que, si une priorité est indiquée pour la puissance active, on détermine d'abord la valeur de consigne maximale autorisée de la puissance active (10a) à délivrer ou à absorber et la valeur de consigne maximale autorisée de la puissance réactive (10b) à délivrer ou à absorber est déterminée en fonction de la valeur de consigne de la puissance active à délivrer ou à absorber, et que,

si une priorité est indiquée pour la puissance réactive, on détermine d'abord la valeur de consigne maximale autorisée de la puissance réactive (10b) à délivrer ou à absorber et la valeur de consigne maximale autorisée de la puissance active (10a) à délivrer ou à absorber est déterminée en fonction de la valeur de consigne maximale autorisée de la puissance réactive à délivrer ou à absorber.

**2.** Procédé selon la revendication 1, **caractérisé en ce que,** pour le calcul des valeurs de consigne maximales autorisées pour la puissance active et la puissance réactive, on a recours au moins à la valeur réelle du courant à limiter pour la correction.

**3.** Procédé selon la revendication 1 ou 2, **caractérisé en ce qu'**une puissance apparente maximale autorisée est déterminée au moyen d'un modèle simplifié de la machine asynchrone (5) à double alimentation à partir du courant maximal autorisé.

4. Procédé selon l'une quelconque des revendications 1 à 3, **caractérisé en ce que,** si une priorité est indiquée pour la puissance active, la valeur de consigne maximale autorisée de la puissance active (10a) à délivrer ou à absorber est déterminée à partir de la puissance apparente maximale autorisée et d'une puissance active de correction (11a), et la valeur de consigne maximale autorisée de la puissance réactive (10b) à délivrer ou à absorber est déterminée à partir de la valeur réelle de la puissance active (2a) délivrée ou absorbée, de la puissance active de correction (11a) et d'une puissance réactive de correction (11b).

5. Procédé selon l'une quelconque des revendications 1 à 3, **caractérisé en ce que,** si l'on indique une priorité pour la puissance réactive, la valeur de consigne maximale autorisée de la puissance réactive (10b) à délivrer ou à absorber est déterminée à partir de la puissance apparente maximale autorisée et d'une puissance réactive de correction (11b), et la valeur de consigne maximale autorisée de la puissance active (11a) à délivrer ou à absorber est déterminée à partir de la valeur réelle de la puissance réactive délivrée ou absorbée (2b), de la puissance réactive de correction (11b) et d'une puissance active de correction (11a) .

6. Procédé selon la revendication 4 ou 5, **caractérisé en ce que** la puissance active de correction (11a) est déterminée au moyen d'une loi d'adaptation à partir de la valeur réelle (2a) et d'une valeur d'approximation pour la puissance active délivrée ou absorbée, la valeur d'approximation étant constituée de la somme de la puissance active de correction (11a) réinjectée et d'une puissance active, qui est déterminée au moyen du modèle simplifié de la machine asynchrone à double alimentation.

7. Procédé selon la revendication 4 ou 5, **caractérisé en ce que** la puissance réactive de correction (11b) est déterminée au moyen d'une loi d'adaptation à partir de la valeur réelle (2b) et d'une valeur d'approximation pour la puissance réactive délivrée ou absorbée, la valeur d'approximation étant constituée de la somme de la puissance réactive de correction (11b) réinjectée et d'une puissance réactive, qui est déterminée au moyen du modèle simplifié de la machine asynchrone à double alimentation.

8. Procédé selon l'une quelconque des revendications 3 à 7, **caractérisé en ce que** la puissance apparente maximale autorisée est déterminée à partir de grandeurs du système direct, et la composante maximale autorisée du système direct du courant est déterminée par réduction du courant maximal autorisé de la composante du système inverse de la valeur réelle du courant.

9. Procédé selon l'une quelconque des revendications 4 à 7, **caractérisé en ce que** la valeur réelle de la puissance active délivrée ou absorbée du système direct est utilisée au lieu de la valeur réelle de la puissance active délivrée ou absorbée et la valeur réelle de la puissance réactive délivrée ou absorbée du système direct est utilisée au lieu de la valeur réelle de la puissance réactive délivrée ou absorbée.

10. Procédé selon l'une quelconque des revendications 6 ou 7, **caractérisé en ce que** des grandeurs du système direct sont utilisées pour déterminer la puissance active et la puissance réactive au moyen du modèle simplifié de la machine asynchrone à double alimentation.

11. Procédé selon l'une quelconque des revendications 1 à 10, **caractérisé en ce que** le courant de rotor de la machine asynchrone à double alimentation est limité.

12. Procédé selon l'une quelconque des revendications 1 à 10, **caractérisé en ce que** le courant du stator de la machine asynchrone à double alimentation est limité.

13. Procédé selon l'une quelconque des revendications 1 à 12, **caractérisé en ce que** la puissance active et la puissance réactive du stator de la machine asynchrone à double alimentation ou la puissance active et la puissance réactive du réseau, auquel la machine asynchrone à double alimentation est raccordée, sont réglées.

14. Dispositif pour le réglage de la puissance active délivrée ou absorbée et de la puissance réactive délivrée ou absorbée d'une machine asynchrone (5) à double alimentation, le dispositif comprenant des moyens pour la limitation d'un courant de la machine asynchrone à double alimentation, les moyens déterminant pendant l'exploitation de la machine asynchrone à double alimentation une valeur de consigne maximale autorisée de la puissance active (10a) à délivrer ou à absorber et une valeur de consigne maximale autorisée de la puissance réactive (10b) à délivrer ou à absorber, à l'aide d'un modèle mathématique de la machine asynchrone à partir du courant maximal autorisé et prédéfini, de telle sorte que le courant (16) maximal autorisé n'est pas dépassé, **caractérisé en ce que** les moyens sont conçus pour limiter les valeurs de consigne prédéfinies de la puissance active et de la puissance réactive aux valeurs de consigne maximales autorisées et calculées de la puissance active et de la puissance réactive,

en que le dispositif comprend des moyens pour l'indication d'une priorité,

**en ce que**, si une priorité est indiquée pour la puissance active, on détermine d'abord par les moyens la valeur de consigne maximale autorisée de la puissance active (10a) à délivrer ou à absorber et on détermine par les moyens la valeur de consigne maximale autorisée de la puissance réactive (10b) à délivrer ou à absorber en fonction de la valeur consigne de la puissance active à délivrer ou à absorber, et

**en ce que**, si une priorité est indiquée pour la puissance réactive, on détermine d'abord par les moyens la valeur de consigne maximale autorisée de la puissance réactive (10b) à délivrer ou à absorber et on détermine par les moyens la valeur de consigne maximale autorisée de la puissance active (10a) à délivrer ou à absorber en fonction de la valeur de consigne maximale autorisée de la puissance réactive à délivrer ou à absorber.

**15.** Dispositif selon la revendication 14, **caractérisé en ce que** celui-ci est conçu également pour mettre en ouvre un procédé selon l'une quelconque des revendications 2 à 13.

**Fig.1**

**Fig.2**

**Fig.3**

**Fig.4**

**EP 2 027 648 B1**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- GB 2411252 A
- GB 2410386 A